Europäisches Patentamt

European Patent Office

Office européen des brevets

(19)

(11) Publication number: **0 145 282**

A2

(12) **EUROPEAN PATENT APPLICATION**

(21) Application number: **84307745.4**

(22) Date of filing: **09.11.84**

(51) Int. Cl.⁴: **H 01 L 27/10**

(30) Priority: **11.11.83 GB 8330112**

(43) Date of publication of application:
**19.06.85 Bulletin 85/25**

(84) Designated Contracting States:
**BE DE FR GB IT NL SE**

(71) Applicant: **SINCLAIR RESEARCH LIMITED**
25 Willis Road
Cambridge CB1 2AQ(GB)

(72) Inventor: **Sinclair, Sir Clive Marles**
The Stone House 3 Madingley Road
Cambridge(GB)

(74) Representative: **Carpmael, John William Maurice et al,**
CARPMAELS & RANSFORD 43 Bloomsbury Square
London, WC1A 2RA(GB)

(54) Semiconductor device.

(57) An integrated circuit shift register comprising regions (11,13,15 and 17) of n type semiconductor material formed by diffusion in a p- type epitaxy (3) formed on a substrate (5). Overlying each region (11,13,15 and 17) is a shallow diffusion of p type material (19,21,23 and 25), each provided with a projection (27,29,31 and 33) overlying the epitaxy material (3) between the regions (11,13,15 and 17) of n type semiconductor material. The regions of n type semiconductor material (11,13,15 and 17) each form common emitter and collector regions of adjacent bipolar lateral transistors in a series, the projections (27,29,31 and 33) form base contacts and the region of overlap between the shallow diffusions of p type material (19,21,23 and 25) and the regions of n type material (11,13,15 and 17) form a capacitor in the form of a reversed biased PN junction. A clocking pulse applied sequentially to the shallow diffusions of p type material causes movement through the shift register of data stored as voltages in the reverse biased PN junction. The clocking pulse sets up a potential gradient in the epitaxy (3) which restricts unwanted carrier injection into the substrate.

FIG. 2

## Semiconductor Device

The present invention relates to a semiconductor device and in particular to an integrated circuit shift register.

The production of integrated circuits involves the sequential layering of various materials upon or within a silicon substrate. A slice of silicon is first cut from a single crystal pulled from a silicon melt. The slice, after polishing, may then have a layer of pure silicon known as an epitaxial layer deposited upon its surface. The epitaxial layer is formed by heating the slice in an atmosphere of hydrogen containing silicon tetrachloride, and may contain dopants, the level of which may be closely controlled. Doping of defined regions of the substrate or the epitaxial layer to form elements of the integrated circuit is achieved by first coating the surface with a lithographic resist. This may be for example a photosensitive resist, regions of which may be made resistant to, or susceptible to, removal, by exposure to light, usually ultra violet light. The photoresists are commonly exposed through a mask and the process generally is known as masking. Impurities may be added to the substrate or to the epitaxial layer in regions not covered by the lithographic resist, thereby forming doped regions of defined geometry. The dopants may be introduced by diffusion, in which the silicon slice is heated to a high temperature in an atmosphere containing the dopant or by ion implantation in which ions of the dopant are accelerated by a high potential gradient and caused to impinge upon the surface of the slice where they force their way into the surface.

If required, a doped diffusion is formed in the silicon substrate prior to the growth of an epitaxial layer. The masking and production of diffusions is repeated with different geometries of mask, different dopants, different depths of penetration etc. until the requisite layer structure has been produced in the silicon substrate and/or epitaxial layer.

Interconnections between the various regions of the integrated circuit are made by laying down insulating layers of, for example, silicon dioxide with connection windows formed therein, alternating with metallic layers. Aluminium is commonly used as the metallic connecting layer, and is usually deposited using the techniques of vacuum deposition in which aluminium vapour produced in a vacuum is allowed to condense upon the slice. The above process may be used to produce a large number of integrated circuits or dice, upon each slice of silicon. A finished slice is cleaved to produce individual integrated circuits.

A standard bipolar transistor is formed in an integrated circuit in the following way. In a p type substrate an $n^+$ type buried layer diffusion is first formed. The $n^+$ type buried layer serves to form a relatively low resistance path for collector current in the completed device. An epitaxial layer of n type material is then grown over the surface of the substrate. Deep diffusions of p type material are then made which penetrate the epitaxial layer, resulting in an isolated region of n type material (including the $n^+$ type buried layer), the region of n type material being completely surrounded by p type material. In use, the substrate is maintained at a negative potential with respect to the remainder of the components on the integrated circuit, the n type region thereby being electrically isolated by means of a reversed biased pn junction. It is desirable to isolate individual transistor elements of an integrated circuit to prevent carrier emission into the substrate which may lead to interference between neighbouring transistor elements and power loss. Isolation is particularly necessary in integrated circuits having a large device density. The n type region forms the collector of the transistor and into the surface of the n type region is diffused a p type base region having diffused into it, in turn, an n type emitter region. In order to prevent undesirable Schottky action an $n^+$ type diffusion is usually provided to interface the n type material with metal contacts. Following all the diffusions, an insulating layer provided with contact windows is laid over the slice, the surface is metallised, and the metal is etched to provide the requisite contact paths.

The process described above presents many difficulties in preparing working integrated circuits. In order to produce a simple transistor a minimum of six masks is necessary (buried layer, isolation, base, emitter, contact window and interconnection). At each masking after the first, accurate registration of subsequent masks is essential. In view of the inherent inaccuracies in registration, the geometries of individual circuit elements must be designed to afford the maximum tolerance for registration consistent with acceptable circuit density. Nevertheless the yield of functioning circuits diminishes rapidly as the number of masks is increased as a result, at least in part, of registration inaccuracy. The cost of preparing further masks and the diminished yield restricts the commercial viability of integrated circuits involving a large number of masks.

In addition, the standard process results in integrated circuits having large steps in the surface of the integrated circuit caused by oxide layers built up during diffusion steps. The oxide layers are of a thickness correlated with the depth of diffusion. The standard process requires a deep p type diffusion to provide an isolation ring about each device. This creates a relatively thick oxide layer and a relatively large step up from the general plane of the integrated circuit, over which, in a subsequent stage of the process, the metallic layer must be laid. Such steps often result in discontinuities in the metal interconnections and the resulting failure of the integrated circuit.

There is now a demand for greater circuit integration particularly in the area of memory circuits. The level of integration is restricted by the need for device isolation and the process constraints brought about by the lithographic techniques employed.

The object of the present invention is to provide an integrated circuit shift register which may be formed with a small number of masking operations, which has a high device density and which affords effective device isolation.

In published United States patent specification No. 4 205 333 there is described a bipolar lateral transistor which is encircled by a shallow diffusion region of the same material as the transistor substrate, but more heavily doped. The specification describes the problem of unwanted minority carrier injection into the substrate and the advantages of reducing such unwanted injection. The problem is solved by the provision of the encircling shallow diffusion region, which forms an electrode, and which, when suitably biassed, sets up a potential gradient between itself and the base region of the device. This limits carrier injection to a small region disposed between the emitter and base regions.

In published U.S. patent specification No. 3912944 there is described a "Bucket Brigade" memory device comprising a series of transistors linked in a chain with collector-to-emitter connections between successive transistors. Switching pulses are applied to the bases of the transistors, which clock input signals along the chain. At each transistor in the chain, the signal is retained as a voltage across a reverse biassed collector/base junction.

According to the present invention we provide an integrated circuit shift register comprising:

i) a substrate provided with

ii) three or more regions of a first doped semiconductor material, each pair of adjacent regions of the first doped semiconductor material being separated by

iii) a region of a second doped semiconductor material, the second doped semiconductor material being complementary to the first doped semiconductor material each region of the first semiconductor material forming the emitter of a first bipolar lateral transistor and the collector of a second adjacent bipolar lateral transistor, each region of the second doped semiconductor material forming the base of a bipolar lateral transistor such that the regions together form two or more bipolar lateral transistors in series

iv) connection means to the base of each bipolar lateral transistor and

v) means forming a capacitor between the base and collector of each bipolar lateral transistor.

The shift register comprises, in effect, a bucket brigade shift register to which clocking pulses may be applied to shift data through the register. The clocking pulses are applied to the connection means to the base of each bipolar lateral transistor. The clocking pulses set up a potential gradient in the substrate which limits the extent of unwanted carrier injection into the substrate. Considering one lateral transistor in the shift register.

If, for example, the lateral transistor is an npn device, biased such that the emitter/base junction is forward biased (i.e. with a positive bias on the base due to a clocking pulse) and the base of each adjacent lateral transistor is at ground potential, emission will occur at the emitter. However as a result of the potential gradient from the base contact to the base of the adjacent lateral transistors only a part of the emitter region close to the base region will be sufficiently forward biased for conduction to occur the rest of the emitter being insufficiently forward biased by virtue of the potential gradient. This effect controls the spatial extent of emission, thereby reducing power losses and negating the need for independent isolation between devices on an integrated circuit.

The term "complementary" as used herein refers to the dopant used in the semiconductor. Where the substrate is p type material the emitter and collector will be formed of n type material (forming a lateral bipolar npn transistor) and where the substrate is n type material the emitter and collector regions will be formed of p type material (forming a lateral bipolar pnp transistor). The relevant dopants used may be those common in the art. The emitter and collector regions may be simultaneously formed by the known processes of, for example, diffusion or ion implantation.

Preferably the first doped semiconductor material is n type material and the second doped semiconductor material is p type material, thereby forming a series of npn bipolar lateral transistors, each transistor having an emitter common with the collector of an adjacent transistor to one side and a collector common with the emitter of adjacent transistor to the other side. It will be understood that regions of first or second semiconductor material at each extreme of the shift register form incomplete transistors where the interfacing of the shift register with a connection or other circuit(s) occurs.

The regions of first doped semiconductor material are preferably regions formed in a substrate of the second doped semiconductor material. Other constructions of the regions are however possible. For example, the regions of semiconductor material may be formed upon an insulating substrate. Most preferably the first doped semiconductor material is n+ type material and the substrate and the second doped semiconductor material are p- type material.

The connection means to the base of each bipolar lateral transistor may be for example metallic but is preferably a semiconductor of the same type as the substrate but more heavily doped. Most preferably where the substrate is p- type material, the connection means comprises a p+ type region.

The means forming a capacitor is preferably formed by a pn junction formed between the connection means and a region of the first doped semiconductor material.

The number of lateral bipolar transistors which may be formed into a shift register of the invention is limited effectively only by the size of substrate upon which the integrated circuit may be formed.

In a further aspect of the invention we provide an integrated circuit including a serial memory comprising one or more shift registers of the invention. Preferably each shift register forms a row in a matrix, the connection means to the bases of the lateral bipolar transistors in each column being common. A plurality of shift registers of the invention may be provided on an integrated circuit in combination with other circuitry. In particular circuitry may be included to link one or more shift registers together to form an adjustable length shift register (i.e. adjusting memory capacity) or to avoid defective shift registers in an integrated circuit.

The integrated circuit shift register of the invention has many advantages. The process for manufacturing the integrated circuit is simple, requiring only two diffusions, one for the emitter and collector regions and a second for the base and connection means if these are of the semiconductor type. The diffusions are relatively shallow and do not result in large growths of oxide. Since the total minimum number of masks is only four (emitter/collector, base/connection means, contact windows, interconnection) the process yield is increased and the cost reduced. Furthermore since the number of mask registrations is reduced, the individual regions can be made smaller since a reduced allowance for malregistration may be made. This factor, coupled with the removal of a necessity for isolation barriers and the dual use of certain circuit elements markedly increases the possible density of circuitry which may be realised. It is possible to produce memory elements in this way which are about 10 times smaller than elements of similar capacity using conventional devices. Indeed large numbers of transistors may be formed in two masking steps without the need for a separate metallic interconnection layer over the entire integrated circuit.

Interconnection between devices may be made by heavily doped semiconductor material of the same type as the substrate. Connections between the integrated circuit and its mounting may be made via metallic connections for example at the edge of the integrated circuit. Finally the characteristics of the transistors are reproducibly good due to the active regions of the complete device being formed using one mask. This allows accurate control of the geometry of each device. In particular using the lithographic processes of the art it is possible to form transistors with a very narrow base region (of the order of 1 micron). This produces devices having high gain, high $f_T$ values.

The invention is now described by way of example with reference to the accompanying drawings in which:

Figure 1 is a circuit diagram showing, in discrete components, a Bucket Brigade circuit,

Figure 2 is a plan view of a portion of a serial memory of a prefered embodiment of the invention, and

Figure 3 is a section on the line A-A in Figure 2.

Example 1

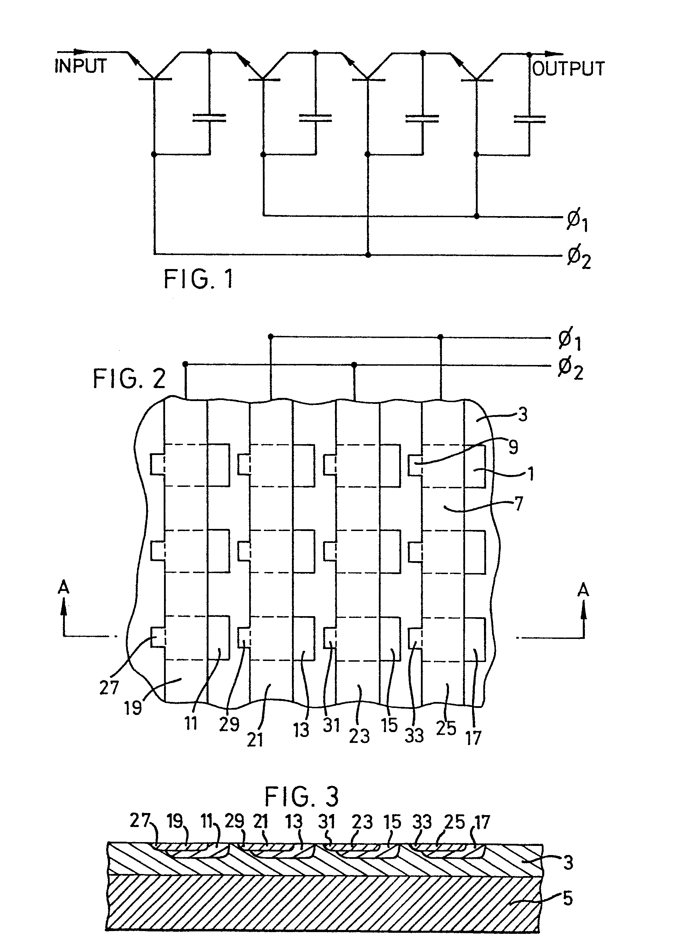

In this example the integrated circuit shift register of the present invention is applied to the production of a serial memory integrated circuit. The basis of the circuit is shown by the representation in discrete components in Figure 1. This circuit is a bipolar version of the "Bucket Brigade" charge transfer circuit known for use with field effect devices. Digital input bits are clocked through the circuit by complementary clock pulses applied to clock lines $\phi_1$ and $\phi_2$. The effect of clocking is to pass the digital signal along the capacitors connected between the base and collector of each transistor. The circuit of Figure 1 acts as a two bit shift register. Figure 2 shows a plan view of part of an integrated circuit embodying transistors of the present invention. The portion of the integrated circuit shown comprises three two bit shift registers of the type depicted in discrete form in Figure 1.

The integrated circuit shown in Figure 2 comprises a matrix of separate $n^+$ type regions (e.g. 1) formed in a $p^-$ type surface layer 3 in turn formed on a $p^+$ type substrate 5. The $n^+$ type regions are each rectangular in plan and are disposed in the $p^-$ type layer 3 with their longitudinal axes aligned along rows of the matrix. The separation between $n^+$ type regions in adjacent columns of the matrix is less than the separation between $n^+$ type regions in adjacent rows of the matrix. Continuous $p^+$ type strips (e.g. 7) are formed in the surface running down each column of $n^+$ type regions. The $p^+$ type strip of each column is formed in the $p^-$ type layer and in a portion of the left side of each $n^+$ type region in the column. The $p^+$ type strip is provided with projections (e.g. 9) formed in the $p^-$ type layer 3 to the left of each $n^+$ type region in the column. Each row of $n^+$ type regions forms a shift register and for the purposes of this description the two bit shift register formed by the lowest row of $n^+$ type regions in Figure 2 will now be described. The $n^+$ type regions 11, 13, 15 and 17 form the collectors and emitters of adjacent transistors of the Bucket Brigade device. Each $n^+$ type region fulfills a dual function, the left side of each of the $n^+$ type regions acting as a collector and the right side of each of the $n^+$ type regions acting as an emitter. The $p^+$ type strips 19, 21, 23 and 25 provide, through their projections 27, 29, 31 and 33, connections to base regions formed in the $p^-$ type layer between adjacent $n^+$ type regions in the row. The junction between the $p^+$ type strips and each $n^+$ type region forms a pn junction of finite capacitance. By analogy with the circuit diagram of Figure 1 therefore a transistor is formed by the right side of an $n^+$ type region, the left side of an adjacent $n^+$ type region (for example, emitter 13; collector 15) and the region of $p^-$ type material between the two $n^+$ type regions (base). Electrical connection to the $p^-$ type (base) region is by means of a projection 31 formed from a $p^+$ type strip 23 and a capacitor between the $n^+$ type region (collector) and the $p^-$ type (base) region is formed by a pn junction. In operation the shift register formed by the integrated circuit of Figure 2 is analogous to the discrete circuit of Figure 1.

Positive clock pulses are applied at $\phi_1$ and $\phi_2$ such that at any time if one $p^+$ type strip is at a positive potential the $p^+$ type strips to either side are at zero potential. The arrangement of the circuit and the clock pulses $\phi_1$ and $\phi_2$ is such that when for example the projection 31 forming a base contact is at a positive potential, the adjacent base contact 29 is at zero potential. This sets up a potential gradient in the $p^-$ type layer 3. Thus whenever the emitter/base junction formed by the right side of $n^+$ type region 13 and the $p^-$ type layer 3, is forward biased, the potential gradient does not allow a sufficient forward bias for emission over most of the emitter/base junction. Carrier emission is therefore restricted into, or very near to the region between $n^+$ type region 13 and $n^+$ type region 15. The geometry of the projection 31 further restricts the spatial extent of carrier emission from the emitter 13. The use of a potential gradient produced in the substrate of the integrated circuit by the clocking pulses to reduce spurious carrier emission into the substrate removes the need for isolation of the individual lateral transistors.

It will be seen therefore that by means of a very few diffusions (e.g. as few as two) a high density memory can be produced using one or more shift registers of the invention. The use of metal interconnections and contacts is kept to a minimum since connections to a serial memory, such as described, need only be made at the edges of the array. The number of diffusions used is small - only two diffusions masks being necessary and therefore registration problems are reduced to a minimum. If necessary physical isolation may be provided between adjacent shift registers to avoid any possible loss of gain through injection from an emitter in one shift register to the collector of an adjacent shift register. The formation of a potential gradient within the substrate of the integrated circuit may result in a significant power loss. This problem may be conveniently surmounted by providing clock pulses which are of relatively short duration; for example at a mark space ratio of about 1:10.

- 13 -

0145282

CLAIMS:-

1. An integrated circuit shift register comprising:

i) a substrate (3) provided with

ii) three or more regions (11,13,15,17) of a first doped semiconductor material, each pair of adjacent regions of first doped semiconductor material being separated by

iii) a region of a second doped semiconductor material, the second doped semiconductor material being complementary to the first doped semiconductor material each region of the first semiconductor material forming the emitter of a first bipolar lateral transistor and the collector of a second adjacent bipolar lateral transistor, each region of the second doped semiconductor material forming the base of a bipolar lateral transistor such that the regions together form two or more bipolar lateral transistors in series,

iv) connection means (19,21,23,25) to the base of each bipolar lateral transistor and

v) means forming a capacitor between the base and collector of each bipolar lateral transistor.

2. An integrated circuit shift register according to claim 1 wherein the first doped semiconductor material is n type material and the second doped semiconductor material is p type material, forming a series of npn bipolar lateral transistors, each transistor having an emitter common with the collector of an adjacent transistor to one side and a collector common with the emitter of an adjacent transistor to the other side.

3. An integrated circuit shift register according to claim 2 wherein the first doped semiconductor material is n+ type material and the substrate and the second doped semiconductor material are p- type material.

4. An integrated circuit shift register according to claim 2 or 3 wherein the regions of first doped

- 14 -

**0145282**

semiconductor material are regions formed in a substrate of the second doped semiconductor material.

5. An integrated circuit shift register according to claim 1 wherein the regions of semiconductor material are formed upon an insulating substrate.

6. An integrated circuit shift register according to any one of claims 1 to 4 wherein the connection means to the base of each bipolar lateral transistor is a more heavily doped semiconductor of the same type as the substrate.

7. An integrated circuit shift register according to claim 6 wherein the substrate is p- type material and the connection means comprises a p+ type region.

8. An integrated circuit shift register according to any one of claims 1 to 7 wherein the means forming a capacitor comprises a pn junction between the connection means and a region of the first doped semiconductor material.

9. An integrated circuit including a serial memory comprising one or more shift registers according to any one of claims 1 to 8.

10. An integrated circuit according to claim 9 wherein each shift register forms a row in a matrix, the connection means to the bases of the lateral bipolar transistors in each column being common.

0145282

1/1

FIG. 1

FIG. 2

FIG. 3